Europäisches Patentamt

European Patent Office

Office européen des brevets

(19)

(11) Publication number: **0 344 838**
**A2**

---

(12) **EUROPEAN PATENT APPLICATION**

(21) Application number: **89201307.9**

(22) Date of filing: **22.05.89**

(51) Int. Cl.⁴: **H05K 9/00 , H01F 1/08 , H01F 1/09 , H01F 1/113**

---

(30) Priority: **03.06.88 GB 8813120**

(43) Date of publication of application:
**06.12.89 Bulletin 89/49**

(84) Designated Contracting States:
**DE FR GB IT NL**

(71) Applicant: **SHELL INTERNATIONALE RESEARCH MAATSCHAPPIJ B.V.**
**Carel van Bylandtlaan 30**
**NL-2596 HR Den Haag(NL)**

(72) Inventor: **Alsem, Wilfred Hendrik Henri**
**Westervoortsedijk 67D**
**NL-6827 AT Arnhem(NL)**
Inventor: **Rensen, Cornelis**
**Westervoortsedijk 67D**
**NL-6827 AT Arnhem(NL)**
Inventor: **Van Houten, Theodorus Johannes**
**Dr. van Zeelandstraat 1**
**NL-2265 BD Leidschendam(NL)**

(74) Representative: **Aalbers, Onno et al**
**P.O. Box 302**
**NL-2501 CH The Hague(NL)**

---

(54) **Composite materials suitable for magnetic and electronic shielding as well as for permanent magnets.**

(57) Composite material comprising a metal matrix in which the metal is a non-ferri- or a non-ferro-magnetic, electroconducting alloy and a particulate ferri- or ferro-magnetic filler. The composite material may be used as magnetic and/or electronic shielding material as well as for the manufacturing of permanent magnets.

EP 0 344 838 A2

# COMPOSITE MATERIALS SUITABLE FOR MAGNETIC AND ELECTRONIC SHIELDING AS WELL AS FOR PERMANENT MAGNETS

The present invention relates to composite materials. These composite materials are suitable for use as magnetic and electronic shielding materials as well as for the manufacturing of permanent magnets. The composite materials of the present invention comprise a continuous metal matrix in which filler particles are embedded.

Due to recent developments in the electronic industry there is a growing demand for materials having magnetic and electronic shielding properties. Materials having ferri- or ferro-magnetic properties, for instance ferrites and iron, nickel, cobalt and alloys thereof, can be used for magnetic, i.e. static magnetic or low frequent electromagnetic, shielding. Materials having electroconductive properties, for instance metals and alloys, can be used for electronic, i.e. high frequent electromagnetic, shielding. Materials having both ferri- or ferro-magnetic properties and electroconductive properties, for instance iron, nickel, cobalt and alloys thereof, can be used for magnetic and electronic shielding simultaneously. Usually, however, the application of iron, nickel, cobalt or alloys thereof has one or more disadvantages, for instance the difficulties to deform the material, the high density, the high corrosivity and the fact that the material cannot be soldered or brazed. In this respect reference is made to U.S. patent 4,647,714, relating to a composite sheet material for magnetic and electronic shielding.

It is observed that shielding materials may be used for shielding sensible parts as electronic part or components and/or magnetic recording media against electronic and magnetic sources, as well as shielding the electronic and magnetic fields generated by the shielded parts itselves, such as electronic parts or components, wires and/or power devices, and thus protecting other sensible parts against deleterious effects.

It is known that materials having electroconductive properties can be used for shielding of electronic (i.e. electromagnetic) high frequent fields by absorbing the electromagnetic energy in the shielding material and changing it to thermal energy. Conventional metals and alloys, usually having a resistance in the order of magnitude of $10^{-6}$ to $10^{-5}$ ohm-cm, may be applied. The minimum required thickness for effective absorption depends on the frequency of the radiation. Using a thickness of 0.01 mm radiation of frequencies of 1 GHz and higher are absorbed, while using a thickness of 0.5 mm radiation of frequencies of 1 Mhz and higher are absorbed. Because many metals do not have ferro- or ferri-magnetic properties, they are not suitable to shield magnetic fields as coming from permanent magnets or transformers. Metals which can be used, for instance iron, nickel, cobalt or alloys thereof, as discussed before, however, are not always suitable. Other types of materials which can be used for electronic shielding are thermosets or thermoplastics which are made conductive by the addition of fillers such as carbon black or metallic fibres. For such plastics the resistance is usually in the range of $10^2$ to $10^{-1}$ ohm-cm. The shielding effectiveness is hence lower by a factor of about $10^2$ to $10^4$. Further, magnetic fields are not shielded by these materials.

Materials for shielding magnetic fields, i.e. static or low frequent electromagnetic fields arising from permanent magnets or transformers, must have a high relative magnetic permeability in order to deflect the field from the device which has to be shielded. Suitable materials are materials having ferro- or ferri-magnetic properties and preferably exhibiting a high initial permeability such as iron, nickel, cobalt and alloys thereof and ferrites, e.g. spinel, garnet and hexagonal ferrites. Ferrites, however, cannot be shaped by deformation processes such as extrusion, rolling or forging. Further, in view of the poor electroconductive properties, ferrites cannot be used for electronic shielding.

The present invention, now, relates to a composite material suitable for magnetic and electronic shielding, comprising a metal matrix in which the metal is a non-ferri- or a non-ferro-magnetic, electroconducting metal or alloy and a particulate ferri- or ferro-magnetic filler. The composite materials can be used for magnetic and/or electronic shielding as well as for the manufacturing of permanent magnets.

The composite materials according to the present invention have good magnetic and electronic shielding properties due to the presence of a continuous electroconducting metal matrix and the presence in the matrix of particulates having ferri- or ferro-magnetic properties.

It is remarked that the terms ferri- and ferro-magnetism relate to the magnetic properties of a material. All materials that are magnetised by a magnetic field are magnetic materials. Magnetism is classified according to the nature of the magnetic response, i.e. diamagnetism, paramagnetism, ferromagnetism, antiferromagnetism, ferrimagnetism, metamagnetism, parasitic ferromagnetism and mictomagnetism (spin glass). Many of the metals are diamagnetic. Some metals, e.g. the platinum and palladium metals, have paramagnetic properties. The alkali metals, copper, silver and gold show paramagnetic as well as diamagnetic properties. Iron, nickel, cobalt and alloys thereof, as well as many of the rare-earth elements are ferromagnetic. When these materials are placed in a magnetic field the permanent magnetic moments of the atom or ions are aligned as a result of a strong positive interaction among neighbouring atoms or ions and the material exhibits a spontaneous magnetisation. In the case where the permanent magnetic moments are aligned antiparallel as a result of strong negative interaction a zero net magnetism may result (antiferromagnetism, e.g. chromium, manganese), or, in compounds containing two or more kinds of atoms or ions with different values of magnetic moment a net magnetism results (ferrimagnetism, e.g. ferrites).

In the composite material according to the invention the metal is suitably chosen from zinc, aluminium, magnesium, copper, titanium or an alloy thereof. Zinc and aluminium, optionally containing some minor amounts of other metals, are preferred. Zinc is especially preferred.

In the composite material according to the invention the particulate ferromagnetic filler is suitably chosen from iron, nickel, cobalt, one or more suitable rear-earth elements or an alloy thereof. Preferably the filler is chosen from iron, nickel, cobalt or an alloy thereof. Suitable examples are iron alloys (e.g. $FeSi_3$), nickel-iron alloys (e.g. $Ni_{75}Cu_5Cu_2Fe_{18}$), iron-nickel-cobalt alloys (e.g. $Ni_{14}Co_{24}Al_8Cu,Fe_{41}$), CuNiFe, CuNiCo, AgMnAl, CoSm and NdFeB. In the composite material according to the invention the particulate ferrimagnetic filler is suitably a ferrite, preferably a ferrite chosen from the classes of spinel, garnet and hexagonal ferrites. Spinel ferrites are a class of ferrites having the general composition $AB_2O_4$ and which are isostructural with the mineral spinel. Examples are $LiFe_5O_8$, $Ni_{1-x}Zn_x Fe_2O_4$ and $Mn_{1-x}Zn_x Fe_2O_4$. Garnet ferrites are a class of ferrites having the general formula $M_3Fe_5O_{12}$ and which are isostructural with the mineral garnet ($M_3Al_2Si_3O_{12}$). Examples are $Y_3Fe_5O_{12}$ and $Gd_3Fe_5O_{12}$. Hexagonal ferrites are a class of ferrites in which the principal component is $Fe_2O_3$, in combination with a divalent oxide such as BaO, SrO or PbO and a divalent transition metal oxide. Examples are $BaFe_{12}O_{19}$, $SrFe_{12}O_{19}$, $BaZn_2Fe_{16}O_{27}$ and $BraSFe_4O_8$.

The composite material according to the invention is preferably a composite sheet or plate material which can be used for the manufacturing of boxes, envelopes used for shielding electronic parts, components or devices and transporting magnetic recording media and/or electronic parts or components, protection cases for magnetic cards, storage files for magnetic recording media, covers for wires, wallpaper, adhesive tapes etc. The composite sheet or plate materials suitably have a thickness between 0.01 and 5 mm, preferably between 0.01 and 3 mm.

The amount of particulate ferro- or ferri-magnetic filler in the composite material is suitably between 25 and 90% by volume, preferably between 30 and 80%, more preferably between 40 and 65%.

When using for instance zinc, aluminium, magnesium, copper, titanium or alloys thereof as the metal component, the composite materials are generally highly corrosion resistant, can be soldered and/or brazed, and may have a relatively low density, as for instance required in aerospace applications. The composite materials can be shaped by extrusion, rolling and/or forging.

The size of the particulate ferro- or ferri-magnetic filler is suitably between 1 and 1000 $\mu m$, more preferably between 1 and 250 $\mu m$, more preferably between 1 and 100 $\mu m$.

The composite materials according to the present invention may be prepared by thoroughly mixing the individual components, followed by compressing, extrusion, rolling etc. Another method to prepare the composite material is by spray-deposition of a molten slurry of liquid metal and filler particles. When prepared by spray-deposition the thickness of the layer is preferably between 0.01 and 0.2 mm.

Beside application as magnetic and electronic shielding materials, another application of the composite material according to the present invention is the manufacturing of permanent magnets, especially where the shape of the magnet has to be accomplished by means of deformation processes. For application in permanent magnets the ferri- or ferro-magnetive fillers preferably have a high induction and a large coercive field. Preferred fillers are $BeO(Fe_2O_3)_6$, $Ni_{14}Co_{24}Al_8Cu_3Fe_{41}$, CuNiFe, CuNiCo, AgMnAl, CoSn and NdFeB.

Illustrative embodiment 1.

A mixture of $Fe_2O_3$ powder, ZnO powder and MnO powder is ball milled, sintered, ball milled and pulverised to obtain a ferritic MnZn powder of an average particle size of 3 mm . This powder is blended with aluminium powder (alloy designation Al 1081) in a one to one volume ratio for 90 minutes. Thereafter the mixture is put in a cylmonothane bag of cylindrical shape, which is sealed by a cover of the same material. The bag is cold isostatically pressed at 400 MPa. The obtained billets, having a density of 90%, are extruded at a temperature of 450°C. The extruded strip, a continuous aluminium matrix in which MnZn ferrite powder particulates are present, can be used for magnetic and electronic shielding.

## Illustrative embodiment 2

Illustrative embodiment 1 is repeated using zinc powder instead of aluminium powder. An extruded strip is obtained comprising a continuous zinc matrix in which the MnZn ferrite powder particles are embedded. The strip can be used for magnetic and electronic shielding.

## Illustrative embodiment 3

A mixture of a hexagonal ferrite powder of $BaO(Fe_2O_3)_6$ (60% vol) and aluminium powder (alloy designation Al 1081, 40% vol) is blended for 90 minutes in a turbulent mixer. Thereafter the mixture is put in a cyl-monothane cylindrical bag which is covered by a lid of the same material. The bag is cold isostatically pressed at a pressure of 400 MPC. The obtained billets, having a density of 90%, are extruded at 450°C into rods of a diameter of 6 mm, suitable for use as permanent magnet.

## Claims

1. A composite material suitable for magnetic and electronic shielding, comprising a metal matrix in which the metal is a non-ferri- or non-ferromagnetic, electroconducting metal or alloy and a particulate ferri- or ferromagnetic filler.

2. Composite material according to claim 1 wherein the metal is zinc, aluminium, magnesium, copper, titanium or an alloy thereof.

3. Composite material according to claim 2 wherein the metal is zinc.

4. Composite material according to any one of claims 1-3 wherein the particulate ferromagnetic filler is chosen from iron, nickel, cobalt, one or more suitable rare earth elements, or an alloy thereof.

5. Composite material according to claim 4 wherein the particulate ferromagnetic filler is chosen from iron, nickel, cobalt or an alloy thereof.

6. Composite material according to any one of claims 1-3 wherein the particulate ferrimagnetic filler is a ferrite.

7. Composite material according to claim 6 in which the ferrite is chosen from the classes of spinel, garnet and hexagonal ferrites.

8. Composite material according to any one of claim 1-7 in which the composite material is a composite plate or sheet material.

9. Composite material according to any one of claims 1-8 in which the amount of ferro- or ferrimagnetic filler is between 30 and 80% by volume, preferably between 40 and 65% by volume.

10. Composite material according to any one of claims 1-9 in which the particle size of the ferro- or ferri-magnetic filler is between 1 and 1000 $\mu m$, preferably between 1 and 250 $\mu m$, more preferably between 1 and 100 $\mu m$.

11. Use of the composite material according to any one or more of claims 1-10 for magnetic and/or electronic shielding.

12. Use of the composite material according to any one or more of claims 1-10 for the manufacturing of permanent magnets.